# EUROPEAN PATENT APPLICATION

(11) **EP 3 912 963 A1**
(43) Date of publication of application: **24.11.2021**
(21) Application number: 21174949.4
(22) Date of filing: 20.05.2021
(51) Int. Cl.: C01G 41/00, C01G 3/00, C01G 5/00, C01G 7/00, H01M 4/02, H01M 4/04

(54) **TRANSITION METAL CHALCOGENIDE FOR PREPARING METAL NANOSTRUCTURES, METAL NANOSTRUCTURES OBTAINED THEREBY, ELECTRONIC INSTRUMENT INCLUDING THE SAME, AND METHOD FOR MANUFACTURING THE SAME**

(30) Priority: 21.05.2020 KR 20200060883
(71) Applicant: Korea Advanced Institute of Science and Technology, Daejeon 34141 (KR)
(72) Inventor: CHOI, Sung Yool, Daejeon 34141 (KR); KIM, Tae In, Daejeon 34141 (KR); PARK, Ick Joon, Daejeon 34141 (KR)
(74) Representative: Botti, Mario

(57) **Abstract**

The present disclosure relates to a transition metal chalcogenide for preparing metal nanostructures, metal nanostructures obtained thereby, an electronic instrument including the same, and a method for manufacturing the same. More particularly, the present disclosure relates to a transition metal chalcogenide for preparing metal nanostructures using transition metal dichalcogenide nanosheets as a reducing agent, metal nanostructures obtained thereby, an electronic instrument including the same, and a method for manufacturing the same.

## Description

### [Technical Field]

The present disclosure relates to a transition metal chalcogenide for preparing metal nanostructures, metal nanostructures obtained thereby, an electronic instrument including the same, and a method for manufacturing the same. More particularly, the present disclosure relates to a transition metal chalcogenide for preparing metal nanostructures using transition metal dichalcogenide nanosheets as a reducing agent, metal nanostructures obtained thereby, an electronic instrument including the same, and a method for manufacturing the same.

### [Background Art]

A two-dimensional material is a structure formed by strong covalent bonding in a single layer and relatively small Van der Waals force between one layer and another layer, and is chemically stable. Among such two-dimensional materials, transition metal dichalcogenides (also referred to as 'TMD' hereinafter) have different properties (superconductor, semiconductor, metal) depending on compositions of transition metals between an upper chalcogenide element layer and a lower chalcogenide element layer. Particularly, TMD materials having a bandgap have been spotlighted as next-generation semiconductor materials.

A TMD material has a structure of MX₂ (M: transition metal, X: chalcogenide) and is a material including an element of Group 4 to Group 10 and two chalcogen elements bound covalently with one another in the same plane. Such a TMD shows a difference in properties depending on stability and structure derived from a single lattice structure. When the single lattice has a trigonal prismatic shape, TMD shows properties as a semiconductor. In the case of an octahedral shape, TMD shows metallic properties.

TMD having the above-mentioned properties has been given many attentions in various fields by virtue of excellent mechanical, electrical and chemical properties. Particularly, TMD amenable to processing in a solution state has been spotlighted as a novel type of material that shows not only metallic properties but also electrical and catalytic properties suitable and noticeable for wide application in the fields of optoelectronics, energy systems and bioindustry.

Recently, metal nanostructures have been given an increasing attention as candidates substituting for conventional indium tin oxide (ITO) electrodes and capable of solving the problems of indium, such as high cost and unique brittleness, by virtue of high transparency and electrical conductivity. As a method for preparing such metal nanostructures, there has been studied a method of using a catalyst, such as Pt or Ni, or a method of using a reducing agent, such as hydrazine or glucose. However, metal nanostructures obtained by the above-mentioned method have poor physical and optical properties, and thus electrodes and conductors using such metal nanostructures provide low electrical and optical properties undesirably.

### [References]

### [Patent Documents]

Korean Patent Laid-Open No. 10-2012-0100340 ('Method for Growing GaN Nanowires Using Pt Catalyst')

### [Disclosure]

### [Technical Problem]

A technical problem to be solved by the present disclosure is to provide metal nanostructures prepared by using a novel reducing agent and having excellent properties, and a method for preparation thereof and use thereof.

### [Technical Solution]

In one general aspect, there is provided a transition metal chalcogenide as a reducing agent for growing metal nanostructures in a solution state.

The transition metal chalcogenide may be any one selected from MoS₂, MoSe₂, MoTe₂, WS₂, WSe₂ and WTe₂.

In another general aspect, there are provided metal nanostructures grown by using a transition metal chalcogenide as a reducing agent.

The metal nanostructures may be grown from the edge site of the transition metal chalcogenide.

The metal nanostructures may have a size determined by the physical dimension of the transition metal chalcogenide.

The metal nanostructures may have a nanowire or nanorod shape.

In still another general aspect, there is provided an electrode including the metal nanostructures.

The electrode may be a transparent electrode.

The transparent electrode may have a transmittance of 85% or more and a haze coefficient of 3% or less.

In still another general aspect, there is provided an electronic instrument including the electrode.

The electronic instrument may be a display.

In yet another general aspect, there is provided a method for preparing metal nanostructures, including the steps of: mixing a metal precursor and a reducing agent including TMD nanosheets to form a mixture; and heat treating the mixture to reduce the metal precursor, thereby forming metal nanostructures.

The reduction of the metal ion of the metal precursor may be initiated at the edge site of the TMD nanosheets.

The mixture may further include a ligand agent that forms a complex with the metal ion of the metal precursor, and the ligand agent forms a complex with the metal ion of the metal precursor to induce anisotropic growth of the metal nanostructures.

The ligand agent may induce anisotropic growth of the metal nanostructures by lowering the stability of the metal nanostructures on one surface thereof through the anion of the metal precursor.

The metal precursor may include at least one metal selected from the group consisting of copper, silver and gold.

The ligand agent may be an amine group-containing compound.

### [Advantageous Effects]

According to the embodiments of the present disclosure, metal nanostructures are grown in a solution state by using TMD as a reducing agent. Particularly, the TMD nanosheets function as an excellent reducing agent and nucleating agent according to the present disclosure. In addition, it is possible to control the size of the metal nanostructures depending on the dimension and thickness of the TMD nanosheets, and thus to obtain high-quality ultrathin metal nanostructures. Further, it is possible to adjust the size of the metal nanostructures by controlling the dimension of the nanosheets, and thus to improve the electrical and optical properties of a transparent electrode based on the metal nanostructures.

### [Brief Description of Drawings]

FIG. 1 is a block diagram illustrating the method for preparing metal nanostructures using TMD nanosheets according to an embodiment of the present disclosure.
FIG. 2 and FIG. 3 illustrate a process for preparing copper wires using TMD nanosheets according to an embodiment of the present disclosure.
FIG. 4 illustrates a process for preparing WS₂ nanosheets according to an embodiment of the present disclosure.
FIG. 5 illustrates an atomic force microscopic (AFM) image of the WS₂ nanosheets according to Example 1.
FIG. 6 illustrates a zeta potential curve (a), UV-Vis. Spectrum (b) and Raman spectrum (c) of WS₂ nanosheets.
FIG. 7 illustrates a high-resolution transmission electron microscopic (HRTEM) image and selected area diffraction (SAED) pattern of the copper nanowires according to Example 2.
FIG. 8 illustrates an energy dispersive spectroscopic (EDS) spectrum and mapping image of the copper nanowires according to Example 2.
FIG. 9 illustrates an X-ray photoelectron spectroscopic (XPS) spectrum of the copper nanowires according to Example 2.
FIG. 10(b) illustrates a transmission electron microscopic (TEM) image of a mixture before heat treatment, and FIG. 10(c) illustrates a TEM image of the mixture after heat treatment.
FIG. 10(d) illustrates an HRTEM image of copper seeds having a penta-twin structure in a nucleation step.
FIG. 10(e) illustrates a TEM image of a step of growing copper wires, and FIG. 10(f) illustrates a TEM image of finished copper nanowires.
FIG. 11 illustrates an EDS spectrum and mapping image of a mixture before heat treatment.
FIG. 12 illustrates an EDS mapping image of copper nanoparticles at the edge of WS₂ nanosheets.
FIG. 13 illustrates an X-ray diffractometry (XRD) pattern of copper nanowires.
FIG. 14 illustrates a TEM image of copper nanowires depending on content of HDA.
FIG. 15 illustrates a TEM image of copper nanowires depending on concentration of WS₂ nanosheets.
FIG. 16 illustrates diameters of copper nanowires prepared by using different types of reducing agents or catalysts.
FIG. 17 and FIG. 18 illustrate dimensions of WS₂ nanosheets depending on sonication time.
FIG. 19 illustrates diameters of copper nanowires depending on sonication time.
FIG. 20 illustrates electrical and optical properties of an ultrathin copper nanowire electrode.
FIG. 21 illustrates an EDS spectrum and TEM image of silver and gold nanowires obtained by using nanosheets.
FIG. 22 illustrates haze vs. transmittance of a transparent conductor based on the copper nanowires according to Example 2 and that of a conventional conductor, and FIG. 23 illustrates transmittance vs. sheet resistance of an electrode based on the copper nanowires according to Example 4 and that of a conventional electrode.

### [Best Mode]

Hereinafter, preferred embodiments of the present disclosure will be described in detail with reference to the accompanying drawings, in which exemplary embodiments are shown, since various changes and modifications may be made within the scope of the present disclosure. However, it should be understood that the following exemplary embodiments are not intended to limit the scope of the present disclosure but cover any modifications, equivalents and substitutions without departing from the spirit and scope of the present disclosure. In the description, details of well-known features and techniques may be omitted to avoid unnecessarily obscuring the presented embodiments.

According to the present disclosure, a transition metal dichalcogenide (TMD) is used as a reducing agent for growing metal nanostructures. Herein, 'TMD' means a transition metal dichalcogenide compound, such as MoS₂, WS₂, MoSe₂, WSe₂, or the like, but is not limited thereto, and all transition metal chalcogenide compounds, such as 1T', 2H', or the like, fall within the scope of the present disclosure.

According to the present disclosure, TMD has high conductivity and catalytic properties, and thus may be used as an effective reducing agent, when metal nanostructures are grown from a precursor through reduction in a solution state. According to the present disclosure, TMD as a reducing agent allows growth of metal nanostructures at the edge site thereof. Therefore, it is possible to grow nanostructures with a desired dimension depending on the size and thickness of TMD sheets. Thus, TMD may functions as a kind of template. Therefore, when growing metal nanostructures through reduction of a precursor in a solution state according to the present disclosure, TMD functioning as a reducing agent is used also as a template which determines the physical dimension of metal nanostructures. As a result, it is possible to grow ultrathin high-quality metal nanostructures through simple exfoliation of TMD without any additional complicate process.

According to the present disclosure, TMD nanosheets are used as a reducing agent for preparing metal nanostructures from a metal precursor.

Herein, the metal precursor refers to a material, such as CuCl₂, AgNO₃ or HAuCl₄, containing any one metal selected from copper, gold and silver, but is not limited thereto.

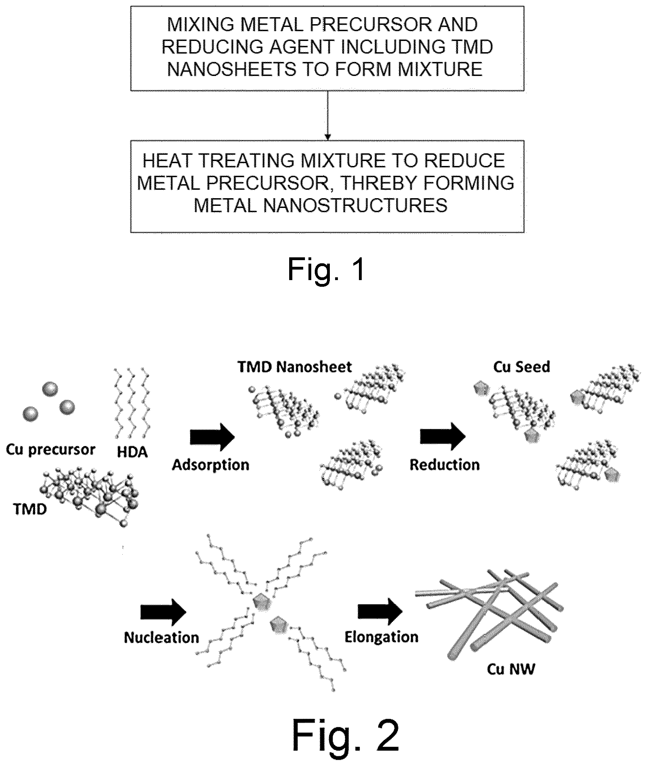

FIG. 1 is a block diagram illustrating a method for preparing metal nanostructures by using TMD nanosheets according to an embodiment of the present disclosure.

Referring to FIG. 1, the method for preparing metal nanostructures using TMD nanosheets includes the steps of: mixing a metal precursor and a reducing agent including TMD nanosheets to form a mixture; and heat treating the mixture to reduce the metal precursor, thereby forming metal nanostructures.

The TMD nanosheets, as a reducing agent, reduce the metal precursor through heat treatment and accelerate crystallization. Particularly, electron conduction proceeds actively at the edge of the TMD nanosheets by virtue of high conductivity to activate reduction of the metal precursor. As the metal precursor is reduced and crystalized by the TMD nanosheets, metal nanostructures are formed through a step of growing metal nanoparticles.

According to an embodiment of the present disclosure, the mixture further includes a ligand agent forming a complex with the metal ion of the metal precursor. The ligand agent forms a complex with the metal ion of the metal precursor to induce anisotropic growth of the metal nanostructures. More particularly, the ligand agent forms a complex with the metal ion of the metal precursor. As the metal ion of the metal precursor is reduced through heat treatment, a specific crystal surface of metal seed crystals is passivated to induce growth of the metal nanostructures toward a specific direction. In addition, the ligand may be an amine group-containing compound, but is not limited thereto.

The size of the metal nanostructures according to an embodiment of the present disclosure may be varied by controlling the size of the TMD nanosheets through tip-sonication. As the sonication time is increased, the size of the metal nanostructures is decreased so that ultrathin metal nanostructures may be obtained.

The metal nanostructures according to an embodiment of the present disclosure may have a nanowire or nanorod shape, but are not limited thereto.

The metal nanostructures obtained according to the present disclosure may have a metal nanowire shape grown through reduction at the edge site of the TMD nanosheets.

In addition, the metal nanostructures obtained according to the present disclosure may be formed into an electrode. There is no particular limitation in the type of the electrode. For example, the electrode may be a transparent electrode.

In addition, the transparent electrode may be incorporated to an electronic instrument, such as a display.

The transparent electrode including the metal nanostructures obtained according to the present disclosure has high transmittance and conductivity and low haze as shown in the following Test Examples, and thus can be used as a high-quality transparent electrode.

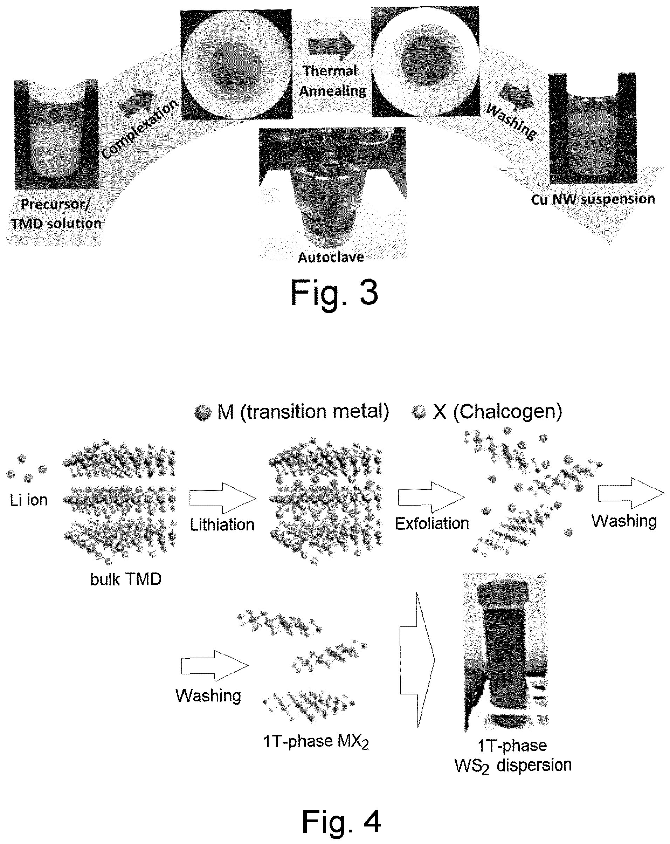

FIG. 2 and FIG. 3 illustrate a process for preparing copper wires using TMD nanosheets according to an embodiment of the present disclosure.

Referring to FIG. 2 and FIG. 3, a ligand agent, hexadecyl amine (also referred to as 'HDA' hereinafter) is added to a mixture of TMD nanosheets with aqueous copper precursor solution to form a blue-colored mixture. Next, the mixture is agitated to accelerate formation of a copper-amine complex and the mixture is annealed in an autoclave at 190°C. Then, copper ions are reduced into copper seeds and {100} surface of copper is passivated by the amine groups of HDA as a ligand agent in the presence of chloride ions. In this manner, selective accumulation is carried out on {100} surface of copper, and thus copper nanowires grow. While the above-mentioned reaction is carried out, the initial blue-colored mixture is changed into a red-colored mixture, which suggests production of one-dimensional copper nanowires.

While the reaction is carried out, the TMD nanosheets play an important role as a reducing agent and nucleating agent. Particularly, reduction of copper ions and crystallization of copper seeds are accelerated at the dichalcogenide edge site of the TMD nanosheets. This is because the dichalcogenide edge site has high conductivity to allow effective conduction of electrons.

Hereinafter, examples and test examples will be explained in more detail.

### [Examples]

### Example 1. Synthesis of WS₂ Nanosheets

WS₂ nanosheets were obtained by exfoliating powder-type (<2 µm, 99%: Sigma Aldrich) bulk WS₂ through chemical intercalation using n-butyl lithium.

More particularly, WS₂ powder was suspended in 1.6 M n-butyl lithium (0.1 g/mL) and agitated vigorously in a glove box filled with nitrogen gas at 60°C for 48 hours. Next, the resultant LiₓWS₂ was collected through filtration and washed repeatedly with hexane to remove excessive lithium and organic residue. Then, the resultant product was redispersed in deionized water (DI). The resultant suspension was treated with tip-sonication in a bath sonicator (JAC Ultrasonic 2020; 40 kHz, 200 W) for 60 minutes, and subjected to centrifugal separation many times at 14,000 rpm for 1 hour until the pH of the suspension becomes neutral. The resultant WS₂ nanosheet dispersion was further subjected to centrifugal separation at 2000 rpm and the supernatant was diluted to a concentration of 0.016 mg/mL. Then, the resultant WS₂ nanosheet suspension was treated with tip-sonication for 1-16 hours by using a sonicator (Sonics & Materials, VC750; 750 W, 20 kHz) to obtain WS₂ nanosheets having different sizes. After the tip-sonication, the WS₂ nanosheet suspension was filtered through a syringe filter to obtain a homogeneous WS₂ suspension having a narrow size distribution, which was further treated with weak tip-sonication for 3 minutes to improve the dispersibility of TMD nanosheets.

FIG. 4 illustrates a process for preparing WS₂ nanosheets according to an embodiment of the present disclosure.

Referring to FIG. 4, WS₂ may be synthesized by exfoliation through chemical intercalation of bulk WS₂ powder to which n-butyl lithium is introduced based on the electron-donating property of lithium. During this process, WS₂ in the state of a metal with an excessive number of d-electrons becomes unstable due to the electron conduction of lithium. In addition, as the electron density in d-orbital is increased, the hexagonal triangular prismatic metal structure is converted into an octahedral metal structure with square symmetry, which suggests conversion of conductivity from a semiconductor to a metal.

### Example 2. Synthesis of Copper Nanowires Using WS₂ Nanosheets

After preparing WS₂ nanosheets, 0.5 mmol of copper (II) chloride dihydrate (CuCl₂·2H₂O, 99.999%, Sigma-Aldrich) was dissolved in DI water and 4 mL of WS₂ nanosheet suspension was added to the solution. In addition, 2.9 mmol of hexadecyl amine (HDA, 98%; Sigma-Aldrich) was added to the solution and the resultant mixture was agitated vigorously at room temperature for 12 hours to accelerate copper-amine complexation. The resultant blue-colored solution was introduced to a Teflon liner and fixed in a stainless steel autoclave at 190°C for 24 hours, followed by cooling to room temperature. The resultant red-colored copper nanowire solution was subjected to centrifugal separation at 8000 rpm and redispersion cycles, and washed with hexane and DI water repeatedly to remove excessive HDA and WS₂ nanosheets. The finished product was dispersed in hexane to carry out further characterization.

### Example 3. Preparation of Silver and Gold Nanowires Using WS₂ Nanosheets

To prepare silver nanowires, 0.045 g of silver nitrate (AgNO₃) and 0.05 g of polyvinyl pyrrolidone were dissolved in DI water. In addition, aqueous suspension of the WS₂ nanosheets (4 mL) prepared as mentioned above was added to the solution and the resultant mixture was agitated vigorously. The resultant opaque white solution was introduced to a Teflon liner and was allowed to stand in a stainless steel autoclave at 170°C for 6 hours, followed by cooling to room temperature. Then, the resultant silver nanowire suspension was subjected to centrifugal separation and redispersion cycles and washed with isopropyl alcohol repeatedly.

In addition, to prepare gold nanowires, 0.04 g of gold (III) chloride (HAuCl₄) was dissolved in hexane, and 0.1 mL of WS₂ nanosheets and 3 µL of oleyl amine were added to the solution. Then, the resultant mixture was agitated vigorously, allowed to stand at room temperature for 6 hours, subjected to centrifugal separation and washed with hexane repeatedly.

### Example 4. Manufacture of Transparent Copper Nanowire Electrode

A copper nanowire electrode was manufactured by a commercially available air brush (Harder & Steenbeck, Infinity) through a spray coating process. Copper nanowires were collected by centrifugal separation and dispersed in ethanol again. A washed glass substrate was treated with UV-ozone plasma for 300 seconds to remove the surface contaminants. The diluted copper nanowire suspension was spray coated onto a glass substrate heated to 120°C on a hot plate. The resultant copper nanowire film was treated with 0.5 M NaBH₄ for 60 seconds to improve contact points and to remove the resultant copper oxide, and then washed with DI water and dried with nitrogen gas together with ethanol.

### [Test Examples]

### Test Example 1. AFM Image Analysis of WS₂ nanosheets

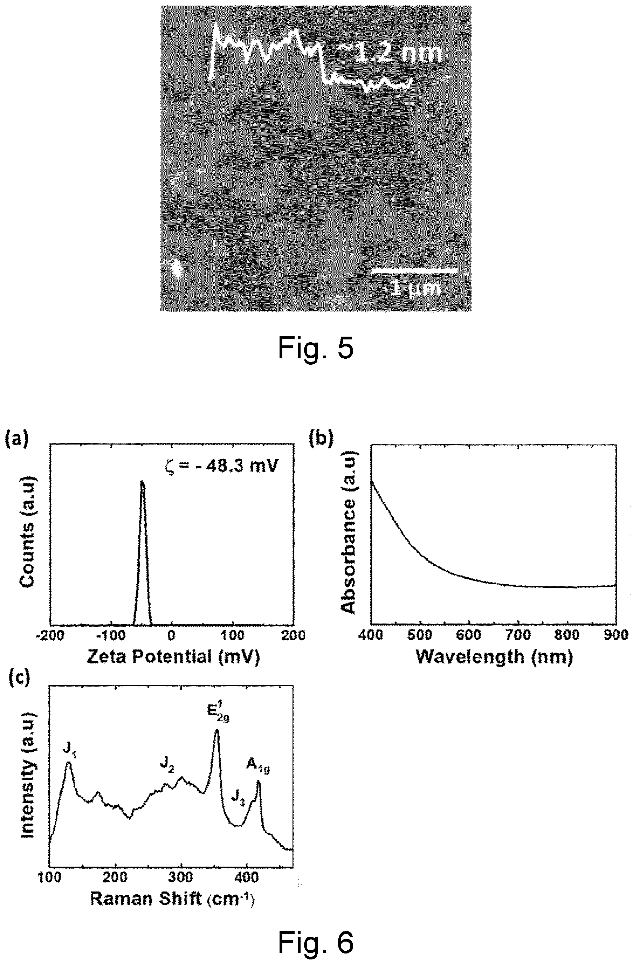

FIG. 5 illustrates an atomic force microscopic (AFM) image of the WS₂ nanosheets according to Example 1.

The AFM image was obtained by stacking the WS₂ nanosheets on a silicon oxide substrate through spin coating.

Referring to FIG. 5, it can be seen from the surface morphology and height profile of the WS₂ nanosheets that the WS₂ nanosheets are present in a single layer having an average thickness of 1.2 nm.

### Test Example 2. Evaluation of Chemical Functionalization and Optical Properties of WS₂ nanosheets

FIG. 6 illustrates a zeta potential curve (a), UV-Vis. Spectrum (b) and Raman spectrum (c) of WS₂ nanosheets.

Referring to FIG. 6, the WS₂ nanosheets have a zeta potential of -48.3 mV, which suggests that the negatively charged WS₂ nanosheets have high stability in aqueous solution (a). In addition, it can be seen from the absorption spectrum of the WS₂ nanosheets that the WS₂ nanosheets have metallic properties, since they undergo no excitation at 628 nm (A band) and 525 nm (B band), unlike the absorption spectrum showing semiconductor properties characterized by direct electron conduction from a valence band to a conduction band (b).

In addition, the WS₂ nanosheets were analyzed by Raman spectroscopy. As a result, the Raman spectrum is characterized by specific J1, J2 and J3 peaks, and E12g mode in the vibration plane positioned at 354 cm⁻¹ and 417 cm⁻¹ and out-of-plane A1g mode become weak as compared to bulk semiconductor-phase WS₂ mode to show formation of metal nanosheets (c). The super-lattice structure of WS₂ having a difference in symmetry has properties of additional conversion in which J1 mode corresponds to the preliminary in-plane stage of one side of a zigzag chain. In addition, J2 peak corresponds to conduction of a S atom layer relative to W atoms, while J3 mode is a small amount of out-of-plane mode and corresponds to stretching vibration of one side of a zigzag chain. The presence of metallic WS₂ is clearly demonstrated from the UV-Vis. absorption spectrum and Raman spectrum.

### Test Example 3. HRTEM Image and SAED Pattern Analysis of Copper Nanowires

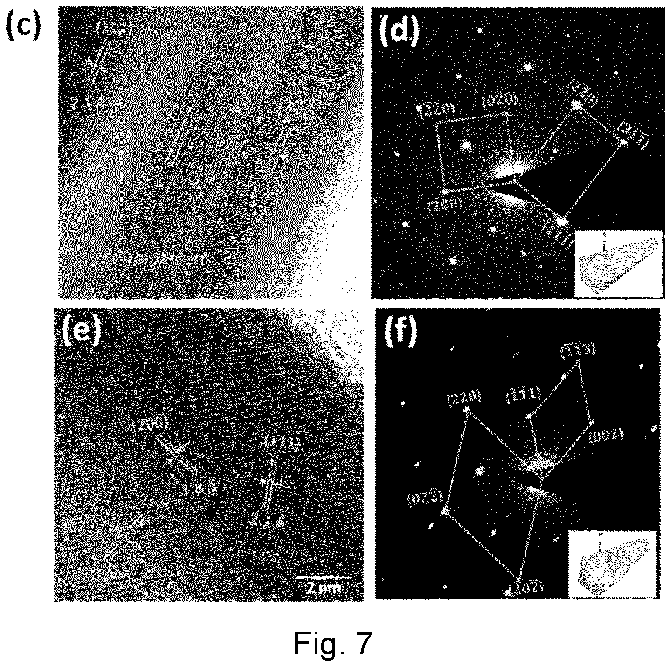

FIG. 7 illustrates a high-resolution transmission electron microscopic (HRTEM) image and selected area diffraction (SAED) pattern of the copper nanowires according to Example 2.

Referring to FIG. 7, HRTEM and SAED of copper nanowires are shown, wherein incident electron beams are irradiated in perpendicular to one of lateral sides of the copper nanowires (c, d). Based on this, the Moire pattern formed by an overlap between the upper unit and the base unit can be observed clearly at the center of nanowires. Schematic views of copper nanowires having five symmetric structures with five single crystal units can be seen from the inserted views of FIG. 7 (d) and (f). In addition, the SAED pattern of copper nanowires along the axis of [110] region shows two sets of face centered cubic diffraction patterns that can be assigned to [112] region and [001] region (d). Therefore, it can be seen from the HRTEM image and diffraction pattern that the copper nanowires have a penta-twin structure, are bound to five {111} surfaces and {100} surfaces at the lateral surfaces, and grow along the longitudinal direction based on a plurality of seeds.

In addition, HRTEM and SAED of copper nanowires are shown, wherein incident electron beams are irradiated in parallel with one of lateral sides of the copper nanowires (e, f). In the HRTEM image, lattice gaps 2.1a° and 1.8a° correspond to {111} surface and {200} surface, respectively, while 1.3a° corresponds to {220} surface of copper nanowires. The direction of copper nanowires is perpendicular to {220} surface. In the SAED pattern of FIG. 7(f), an overlap is observed at the axis of [110] and [111] regions and two FCC patterns. The direction of growth of copper nanowires is determined by [110] direction. In general, growth of metal nanowires with a face centered cubic structure is based on decahedral seeds bound with closed {111} surfaces, not single crystal seeds. In the initial reaction stage, metal nucleation is started and non-homogeneous seed formation is minimized under the effect of Ostwald aging. After copper seeds having a polar decahedral structure are formed, growth of nanowires proceeds along a regular direction by the synergic effect of HDA with chloride ions. As a result, precipitation of copper occurs not on {100} surface but on {111} surface having higher density. More particularly, HDA passivates both {100} surface and {111} surface of copper, or chloride ions reduce the stability of HDA on {111} surface to remove the passivation effect, resulting in selective precipitation on {111} surface. In other words, anisotropic growth occurs on {111} surface by the action and binding of HDA with chloride ions on a specific surface of copper, {111} surface. Therefore, only five pairs of copper seeds grow anisotropically due to appearance-selective disturbance of HDA. As a result, ultrathin nanowires can be grown. In this manner, growth of copper nanowires having a penta-twin structure may be explained.

### Test Example 4. EDS Spectrum and Mapping Image Analysis of Copper Nanowires

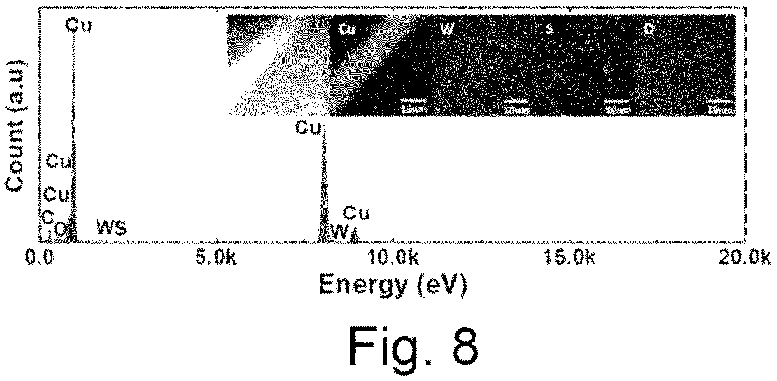

FIG. 8 illustrates an energy dispersive spectroscopic (EDS) spectrum and mapping image of the copper nanowires according to Example 2.

The inserted view of FIG. 8 illustrates an EDS mapping image of each of the ingredients (copper, tungsten, sulfur and oxygen). Referring to FIG. 8, typical signals of copper are detected at 0.81, 0.83, 0.93, 8.05 and 8.9 eV, and a peak of carbon resulting from carbon-coated TEM grids is also detected. In the spectrum, substantially no peaks of tungsten and sulfur atoms are detected and these peaks cannot be identified substantially in the inserted EDS mapping image. This suggests that pure copper nanowires grow and the WS₂ nanosheets functioning as a reducing agent do not participate in the finished product.

### Test Example 5. XPS Spectrum Analysis of Copper Nanowires

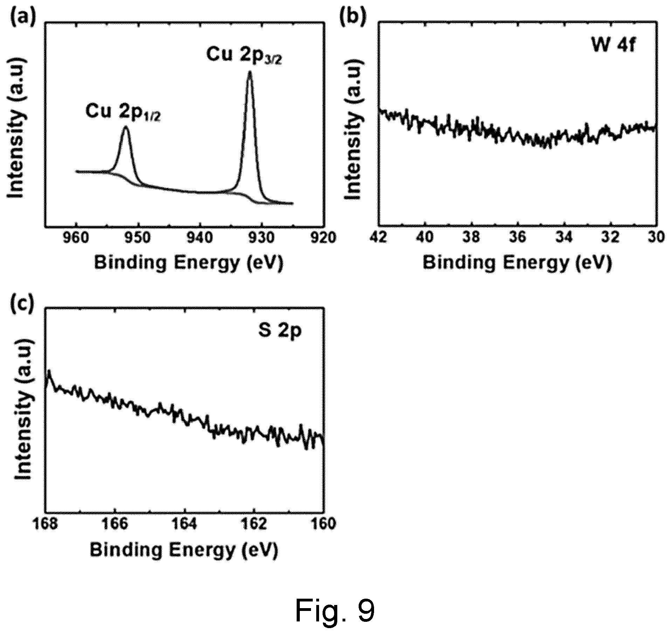

FIG. 9 illustrates an X-ray photoelectron spectroscopic (XPS) spectrum of copper nanowires.

Referring to FIG. 9, the deconvolution Cu2p spectrum of copper nanowires is characterized by 2p1/2 and 2p2/3 peaks at ∼952 and 932 eV, respectively, and shows no shake-up satellite around the 2p peak (a). This suggests that copper nanowires are formed and there is little oxidation of the material surface. No deconvolution W4f (b) and S2p (c) peaks are observed, which conforms to the EDS results suggesting that pure copper nanowires grow without WS₂ nanosheet ingredient in the finished product.

### Test Example 6. TEM Image, EDS Spectrum and Mapping Image Analysis of Mixture before Heat Treatment

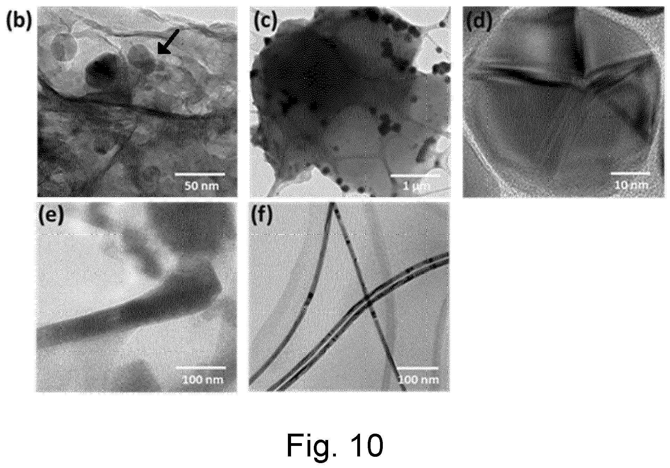

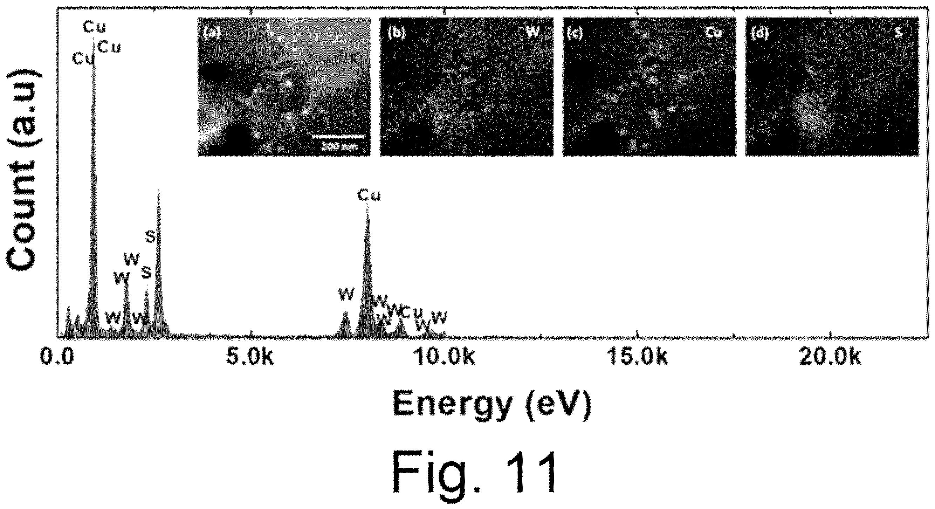

FIG. 10(b) illustrates a transmission electron microscopic (TEM) image of a mixture before heat treatment, and FIG. 11 illustrates an EDS spectrum and mapping image of a mixture before heat treatment.

Referring to FIG. 10(b) and FIG. 11, the copper precursor in the reaction stage before heat treatment is attached to the surfaces of WS₂ TMD nanosheets, as represented by the yellow-colored arrow mark. Considering a high negative zeta potential of the WS₂ nanosheets, the WS₂ nanosheets and copper cations are retained together by electrostatic force to cause simple chemical adsorption of copper cations. It can be seen from the EDS spectrum and the corresponding EDS map of FIG. 8 that not only tungsten and sulfur atoms but also copper ingredients are present on the WS₂ nanosheets. When the temperature is increased subsequently, reduction of copper ions into metallic copper is carried out at the edge site of the WS₂ nanosheets. Herein, it can be seen that the sulfur-terminated edge functions as an active site for effective electron conduction by virtue of high electrical conductivity.

### Test Example 7. TEM Image Analysis of Mixture after Heat Treatment

FIG. 10(c) illustrates a TEM image of the mixture after heat treatment.

Referring to FIG. 10(c), copper nanoparticles are observed predominantly at the edge of the WS₂ nanosheets in the form of dark spots in the TEM image. As a result, it can be seen that the active edge of the TMD nanosheets plays an important role as an efficient catalytic site as compared to the basic plane of TMD.

### Test Example 8. Analysis of HRTEM Image of Copper Seeds and EDS Mapping of Copper Nanoparticles at Edge of WS₂ Nanosheets

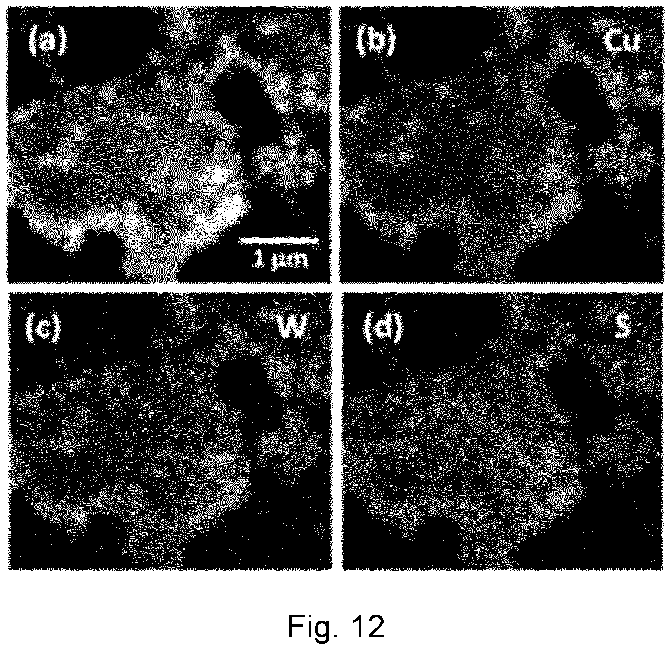

FIG. 10(d) illustrates an HRTEM image of copper seeds having a penta-twin structure in a nucleation step, and FIG. 12 illustrates an EDS mapping image of copper nanoparticles at the edge of WS₂ nanosheets.

Referring to FIG. 10(d) and FIG. 12, copper nanoparticles having a penta-twin decahedral structure clearly demonstrate nucleation of copper seeds having a five-folded twin crystal structure. This is because copper nanoparticles are positioned on a larger plane of the WS₂ nanosheets but the copper seeds are concentrated at the edge of WS₂, as shown in the EDS mapping. The presence of each of copper, tungsten and sulfur on the WS₂ nanosheets can be seen from FIGS. 12 (b)-(d), respectively.

### Test Example 9. TEM Image Analysis of Step of Growing Copper Nanowires

FIG. 10(e) illustrates a TEM image of a step of growing copper wires, and FIG. 10(f) illustrates a TEM image of finished copper nanowires.

Referring to FIGS. 10(e) and (f), as the reaction is carried out for 1 hour, growth of copper nanowires is detected and the copper nanowires are grown with a penta-twin structure as a result of the synergic effect of HDA with chloride ions. More particularly, it can be seen that passivation of the HDA single layer on Cu {111} surface is destroyed selectively by chloride ions. It can be also seen that as HDA which controls anisotropic growth of nanowires is adsorbed strongly and Cu (100) is passivated, deposition on Cu (111) occurs, resulting in production of copper nanowires.

### Test Example 10. XRD Analysis of Pattern of Copper Nanowires

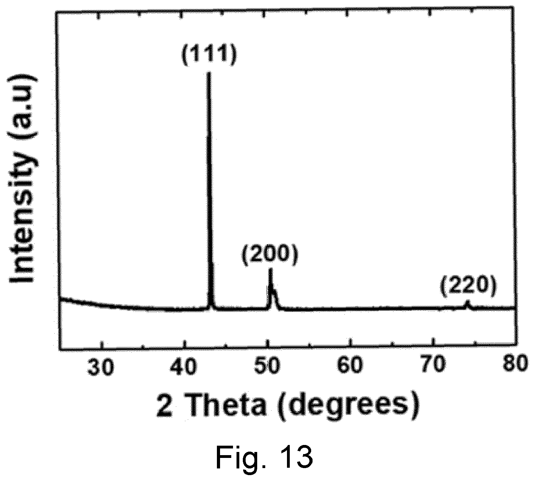

FIG. 13 illustrates an X-ray diffractometry (XRD) pattern of copper nanowires.

Referring to FIG. 13, the XRD pattern demonstrates a face centered cubic structure of copper nanoparticles, wherein three diffraction peaks at 2θ = 43.3°, 50.5° and 74.1° correspond to {110}, {200} and {220} crystal surfaces of copper, respectively. No significant peak derived from impurities is observed. It can be seen from the XRD analysis that copper nanowires having a penta-twin structure are grown satisfactorily.

### Test Example 11. TEM Image Analysis of Copper Nanowires Depending on content of HDA

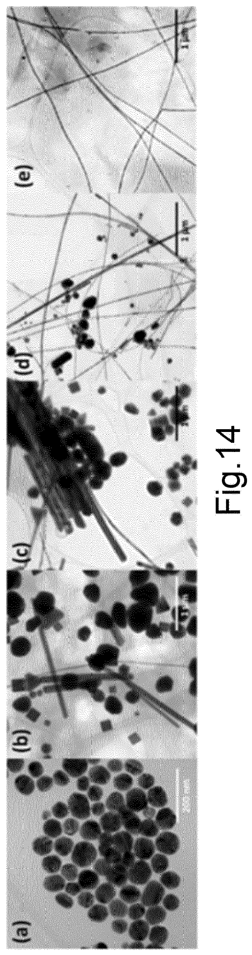

FIG. 14 illustrates a TEM image of copper nanowires depending on content of HDA.

Referring to FIG. 14, when TMD nanosheets are present alone without any ligand agent, copper ions are reduced into copper nanoparticles but growth into nanowire structures does not occur (a). This suggests that TMD nanosheets play an effective role as a reducing agent. However, as the content of HDA is increased (0, 1, 1.5, 2.5 and 2.9 mmol), the product is grown gradually into nanowire structures (b-e). This is because anisotropic growth of copper nanowires occurs due to the passivation on {100} plane. Therefore, it can be seen that HDA contributes to formation of nanowire structures.

### Test Example 12. TEM Image Analysis of Copper Nanowires Depending on Concentration of WS₂ Nanosheets

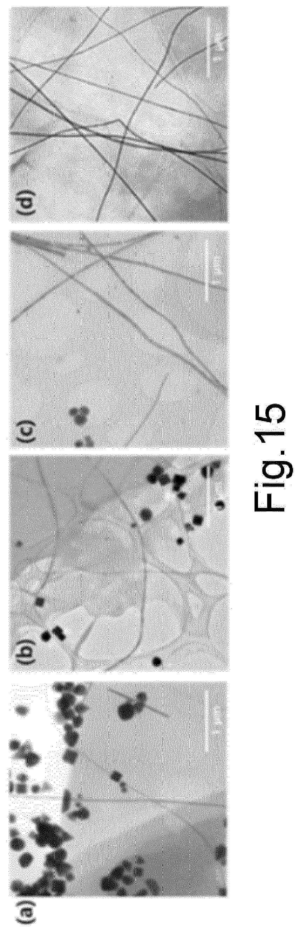

FIG. 15 illustrates a TEM image of copper nanowires depending on concentration of WS₂ nanosheets.

Referring to FIG. 15, as the concentration of WS₂ nanosheets is decreased from 0.16 to 0.016 mg/mL, the content of copper nanoparticles produced from the cooper nuclei concentrated at the active edge of TMD is decreased, while nanowire structures are formed clearly. This suggests that concentration of WS₂ nanosheets affects growth of copper nanowires. Herein, nucleation of copper seeds occurs most actively, when the concentration of WS₂ nanosheets is about 10 times of the content of copper. Therefore, it can be seen that WS₂ nanosheets play an important role as a reducing agent and nucleating agent in preparing copper nanowires.

### Test Example 13. Comparative Analysis of Diameter of Copper Nanowires

The diameter of copper nanowires is closely related with a transparent electrode based on copper nanowires, particularly the characteristic of haze coefficient, which is an important aspect of a transparent electrode. There is an approximately linear relationship between the haze value of a metal nanowire-based electrode and the diameter of metal nanowires. Since light scattering generated by the surface properties of a transparent conductor induces problematic haze and a decrease in sharpness and contrast of an image, it is required for a display device to have a low haze coefficient. Therefore, in order to obtain a high-quality copper nanowire-based transparent electrode with low haze, it is important to obtain ultrathin copper nanowires. The diameter of cooper nanowires may be controlled by various methods. For example, crystallinity may be adjusted by increasing reaction temperature, selecting a weak reducing agent or controlling the molar ratio of a ligand agent to a metal precursor. On the contrary, since TMD nanosheets obtained by tip-sonication have a 2D structure, the dimension of TMD nanosheets may be reduced by etching the materials with ultrasonic energy. In this manner, more edge sites are exposed and the length of nanosheets is reduced. Therefore, copper nanowires having a smaller diameter may be grown.

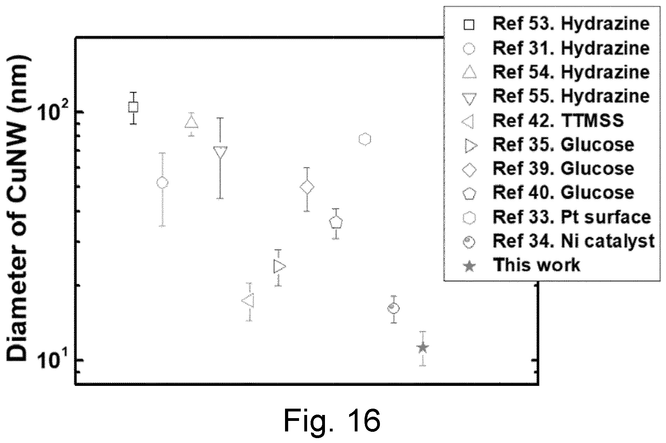

FIG. 16 illustrates diameters of copper nanowires prepared by using different types of reducing agents or catalysts.

Herein, Ref 31 was prepared according to Rathmell, A. R.; Wiley, B. J. The synthesis and coating of long, thin copper nanowires to make flexible, transparent conducting films on plastic substrates. Adv. Mater. 2011, 23, 4798-4803, Ref 33 was prepared according to Zhang, D.; Wang, R.; Wen, M.; Weng, D.; Cui, X.; Sun, J.; Li, H.; Lu, Y. Synthesis of ultralong copper nanowires for high-performance transparent electrodes. J. Am. Chem. Soc. 2012, 134, 14283-14286, Ref 34 was prepared Guo, H.; Lin, N.; Chen, Y.; Wang, Z.; Xie, Q.; Zheng, T.; Gao, N.; Li, S.; Kang, H.; Cai, D.; Peng, D. Copper nanowires as fully transparent conductive electrodes. Sci. Rep. 2013, 3, 2323, Ref 35 was prepared according to Jin, M.; He, G.; Zhang, H.; Zeng, J.; Xie, Z.; Xia, Y. Shape-controlled synthesis of copper nanocrystals in an aqueous solution with glucose as a reducing agent and hexadecyl amine as a capping agent. Angew. Chem. Int. Ed. 2011, 50, 10560-10564, Ref 39 was prepared according to Im, H. G.; Jung, S.; Jin, J.; Lee, D.; Lee, J.; Lee, D.; Lee, J.; Kim, I.; Bae, B. Flexible transparent conducting hybrid film using a surface-embedded copper nanowire network: a highly oxidation-resistant copper nanowire electrode for flexible optoelectronics. ACS Nano 2014, 8, 10973-10979, Ref 40 was prepared according to Ahn, Y; Jeong, Y; Lee, D.; Lee, Y Copper nanowire-graphene core-shell nanostructure for highly stable transparent conducting electrodes. ACS Nano 2015, 9, 3125-3133, Ref 42 was prepared according to Cui, F.; Yu, Y; Dou, L.; Sun, J.; Yang, Q.; Schildknecht, C.; Schierle-Arndt, K.; Yang, P. Synthesis of ultrathin copper nanowires using tris(trimethylsilyl) silane for high-performance and low-haze transparent conductors. Nano Lett. 2015, 15, 7610-7615, Ref 53 was prepared according to Chang, Y; Lye, M. L.; Zeng, H. C. Large-scale synthesis of high-quality ultralong copper nanowires. Langmuir 2005, 21, 3746-3748, Ref 54 was prepared according to Rathmell, A. R.; Bergin, S. M.; Hua, Y-L.; Li, Z.-Y; Wiley, B. J. The growth mechanism of copper nanowires and their properties in flexible, transparent conducting films. Adv. Mater. 2010, 22, 3558-3563, and Ref 55 was prepared according to Chen, Z.; Ye, S.; Stewart, I. E.; Wiley, B. J. Copper nanowire networks with transparent oxide shells that prevent oxidation without reducing transmittance. ACS Nano 2014, 8, 9673-9679.

Referring to FIG. 16, the diameters of copper nanowires prepared by using various methods and reducing agents, including hydrazine, glucose, Tris (TTMSS) and Pt or Ni catalyst can be determined. Copper nanowires obtained by tip-sonication shows the minimum average diameter capable of improving electrical and optical properties, while providing a low haze with which light scattering and haze problems can be minimized in the field of optoelectronics.

### Test Example 14. Comparison of Dimension of WS₂ Nanosheets Depending on Sonication Time

WS₂ nanosheet suspension was subjected to tip-sonication for 1-16 hours by using a tip sonicator (Sonics & Materials, VC750; 750 Watts, 20 kHz) to obtain WS₂ nanosheets having various dimensions. During the tip-sonication, the WS₂ nanosheets were introduced to an ice bath to maintain the reaction temperature. After the tip-sonication, the WS₂ nanosheet suspension was filtered through a syringe filter to obtain homogeneous WS₂ suspension with a narrow size distribution. To improve the specific dispersibility of the WS₂ nanosheets, tip-sonication was carried out for 3 minutes.

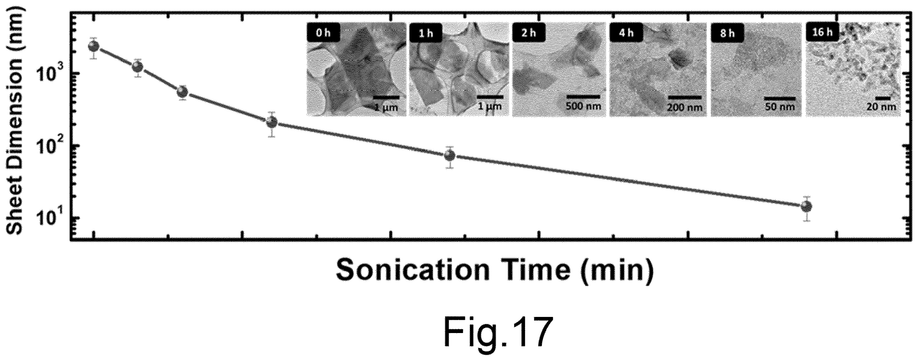

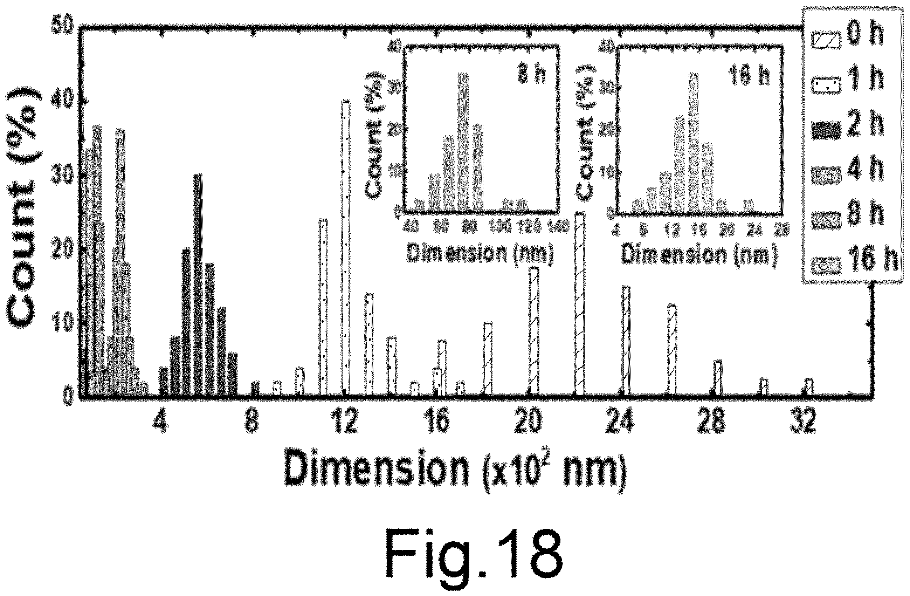

FIG. 17 and FIG. 18 illustrate dimensions of WS₂ nanosheets depending on sonication time.

Referring to FIG. 17 and FIG. 18, as the sonication time is increased, dimension of WS₂ nanosheets is reduced from a micrometer unit to a nanometer unit. In addition, sonication was carried out for 16 hours to obtain WS₂ nanosheets having a dimension of 10 nm. Based on TEM analysis, it can be seen that a sonication time of 1, 2, 4, 8 and 16 hours provide a width dimension of about 1.2 µm, 551.2 nm, 210.1 nm, 730.1 nm and 14.2 nm, respectively.

### Test Example 15. Comparative Analysis of Diameter of Copper Nanowires Depending on Sonication Time

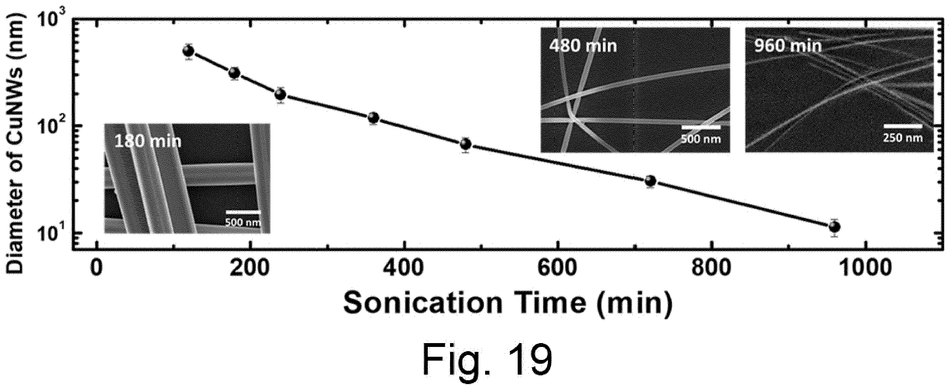

The TMD nanosheets having various dimensions according to Test Example 14 were used to prepare copper nanowires. The results are shown in FIG. 19.

FIG. 19 illustrates diameters of copper nanowires depending on tip-sonication time.

Referring to FIG. 19, the copper nanowires prepared by using TMD nanosheets having various dimensions depending on sonication time have an average diameter of 500.4-11.3 nm. It can be seen that the diameter of copper nanowires is reduced, as the sonication time of TMD nanosheets is increased. The inserted view of FIG. 19 illustrates SEM images of copper nanowires having various diameters and the images correspond to copper nanowires prepared by using TMD nanosheets subjected to tip-sonication for 180, 480 and 960 minutes, respectively, when viewed from the left side.

In addition, it can be seen that the diameter of copper nanowires is significantly affected by the dimension of TMD nanosheets, as compared to FIG. 17. When the dimension of TMD nanosheets is reduced, smaller nanosheets are formed at the active edge site of TMD. Thus, growth of copper nanowires is affected by the TMD nanosheets. In addition, as the dimension of TMD nanosheets is reduced, the number of sulfur-terminated edges of WS₂ functioning as an active catalytic site for reduction and nucleation of copper is increased. Such an increase in active sites affects the number of resultant copper seeds, which, in turn, are grown into nanowires, resulting in a decrease in diameter of nanowires. Therefore, copper nanowires may be grown with a predictable diameter by controlling the dimension of TMD nanosheets within a range of several hundreds of nanometers to 10 nanometers. In other words, the diameter of copper nanometers may be controlled by adjusting the dimension of TMD nanosheets. Further, the method according to the present disclosure allows growth of ultrathin copper nanowires having the smallest diameter. This significantly affects the quality of a metal nanowire film in terms of low sheet resistance and high transmittance, and also affects a decrease in light scattering and haze of a transparent conductor.

### Test Example 16. Evaluation of Electrical and Optical Properties of Copper Nanowire Electrode

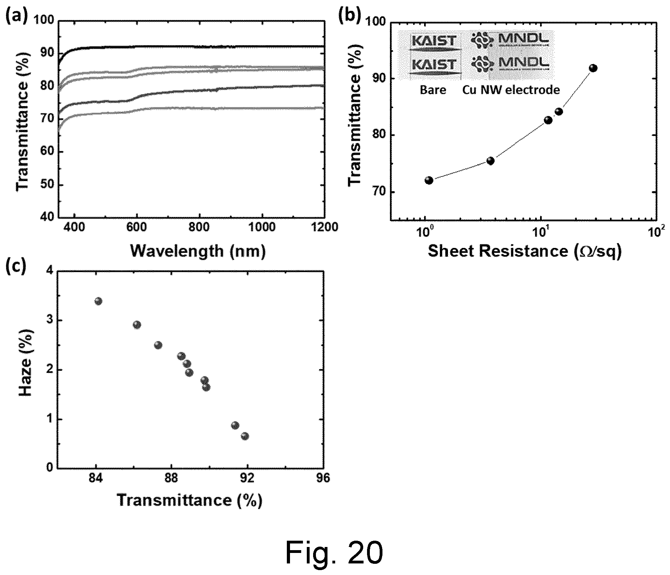

A 4-point probe analysis system and UV-VIS spectrometer were used to evaluate the electrical and optical properties of a copper nanowire electrode. The results are shown in FIG. 20.

FIG. 20 illustrates electrical and optical properties of an ultrathin copper nanowire electrode.

Referring to FIG. 20, the copper nanowire electrode shows a high transmittance from the UV-Vis region to near IR region (350-1200 nm) (a), which suggests that the electrode may be used suitably for a thermal system and photocell requiring light transmittance in the near IR region, as well as for a display. In addition, the sheet resistance of the copper nanowire film is 1.1 ohm/sq at a transmittance of 72% and 3.6 ohm/sq at a transmittance of 75.5%. In other words, the sheet resistance is increased gradually, as the transmittance is increased (b). In the case of the copper nanowires prepared according to the present disclosure, they show a sheet resistance of 28.5 ohm/sq and a transmittance of 91.9%. It can be seen from the result that the copper nanowire electrode obtained according to the present disclosure shows excellent quality and satisfies a trade-off relationship between transmittance and sheet resistance better as compared to a conventional nanowire electrode.

In addition, FIG. 20(c) illustrates a plot of haze coefficient vs. transmittance at a wavelength of 550 nm for the copper nanowire electrode. Herein, haze is defined arithmetically as the percentage of transmitted light scattered within a specific angle (∼2.5°) from the main axis of incident beam, and is a standard metric for quantification of a scattering degree of transmitted light through a transparent conductor. Since strong light scattering reduces the sharpness of an image transmitted through a transparent electrode, it is required to develop a transparent conductor having a low haze value in addition to high conductivity and high transparency for application to displays. The copper nanowire electrode obtained according to the present disclosure shows a haze coefficient of 3.4% at a transmittance of 84.16%. In addition, at a transmittance of 85% or higher, the haze coefficient is 3% or less. More particularly, at a transmittance of 86.2%, the copper nanowire electrode shows a low haze coefficient of 2.9%.

### Test Example 17. EDS Spectrum and TEM Image Analysis of Silver and Gold Nanowires

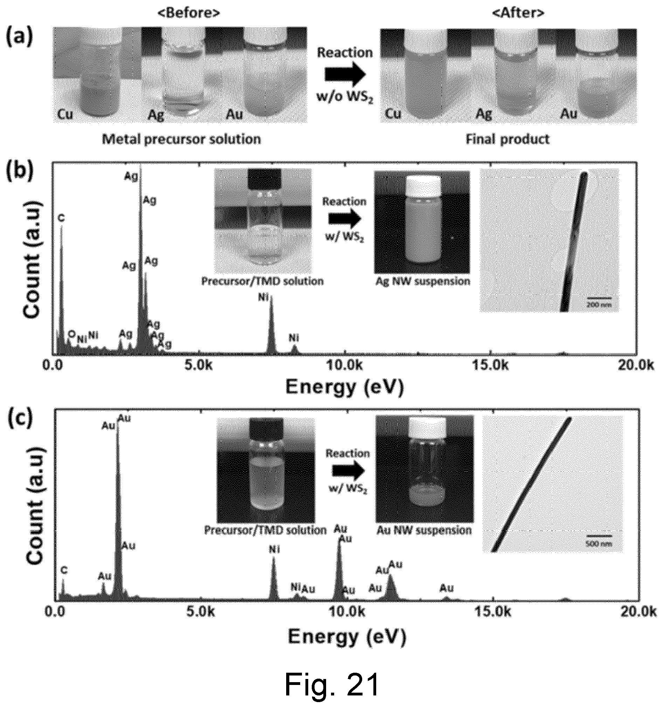

FIG. 21 illustrates an EDS spectrum and TEM image of silver and gold nanowires obtained by using nanosheets.

Referring to FIG. 21(a), the metal precursor solution (copper, silver and gold) having no WS₂ nanosheets before reaction and the corresponding finished product after reaction can be determined. When growth proceeds by using a metal precursor and a ligand agent in the absence of WS₂ nanosheets, no metal nanowires are synthesized. However, when WS₂ nanosheets are added to the reaction solution, silver and gold nanowires are synthesized satisfactorily.

The chemical ingredients of metal nanowires are analyzed by EDS, and the EDS spectra of silver and gold nanowires are shown in FIG. 21(b) and FIG. 21(c), respectively. The inserted views illustrate the photographic image (left side) of the finished product and TEM image (right side) of each type of nanowires. Based on the above results, it is possible to demonstrate the function of WS₂ nanosheets, and thus to recognize high potential of the WS₂ nanosheets as a reducing agent for preparing various metal nanowires.

### Test Example 18. Analysis of Haze Vs. Transmittance and Transmittance Vs. Sheet Resistance of Copper Nanowire-Based Transparent Conductor

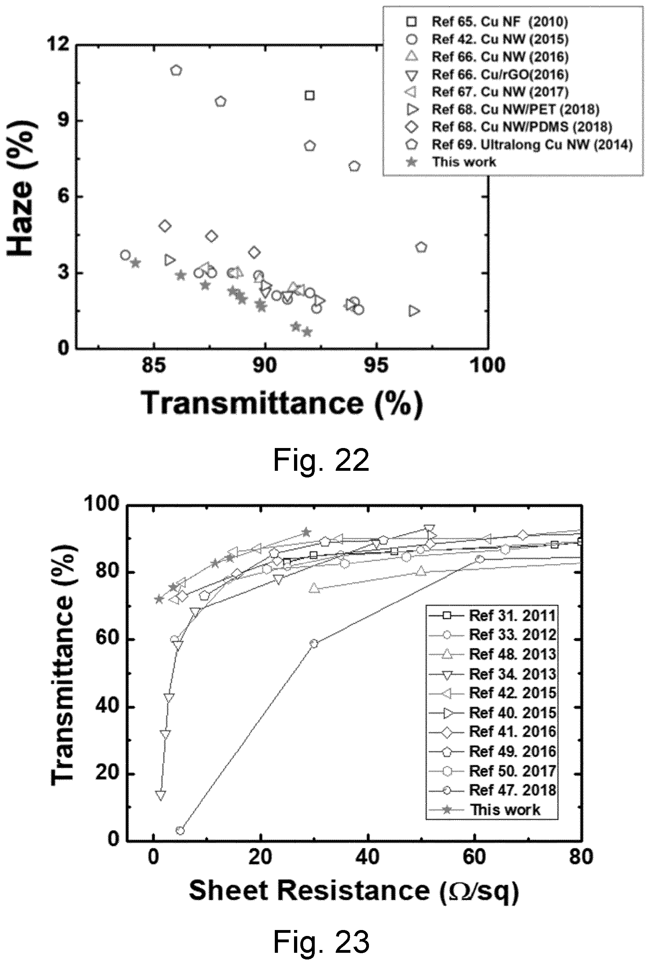

FIG. 22 illustrates haze vs. transmittance of a transparent conductor based on the copper nanowires according to Example 2 and that of a conventional conductor, and FIG. 23 illustrates transmittance vs. sheet resistance of an electrode based on the copper nanowires according to Example 4 and that of a conventional electrode.

Herein, as conventional conductors, Ref 42 was prepared according to Cui, F.; Yu, Y; Dou, L.; Sun, J.; Yang, Q.; Schildknecht, C.; Schierle-Arndt, K.; Yang, P. Synthesis of ultrathin copper nanowires using tris(trimethylsilyl) silane for high-performance and low-haze transparent conductors. Nano Lett. 2015, 15, 7610-7615, Ref 65 was prepared according to Wu, H.; Hu, L.; Rowell, M. W.; Kong, D.; Cha, J. J.; McDonough, J. R.; Zhu, J.; Yang, Y; McGehee, M. D.; Cui, Y Electrospun Metal Nanofiber Webs as High-Performance Transparent Electrode. Nano Lett. 2010, 10, 4242-4248, Ref 66 was prepared according to Dou, L.; Cui, F.; Yu, Y; Khanarian, G.; Eaton, S. W; Yang, Q.; Resasco, J.; Schildknecht, C.; Schierle-Arndt, K.; Yang, P. Solution-processed copper/reduced-graphene-oxide core/shell nanowire transparent conductors. ACS Nano 2016, 10, 2600-2606, Ref 67 was prepared according to Niu, Z.; Cui, F.; Yu, Y; Becknell, N.; Sun, Y; Khanarian, G.; Kim, D.; Dou, L.; Dehestani, A.; Schierle-Arndt, K.; Yang, P. Ultrathin epitaxial Cu@ Au core-shell nanowires for stable transparent conductors. J. Am. Chem. Soc. 2017, 139, 7348-7354, Ref 68 was prepared according to Zhang, Y.; Guo, J.; Xu, D.; Sun, Y.; Yan, F. Synthesis of ultrathin semicircle-shaped copper nanowires in ethanol solution for low haze flexible transparent conductors. Nano Res. 2018, 11, 3899-3910, and Ref 69 was prepared according to Mayousse, C.; Celle, C.; Carella, A.; Simonato, J. P. Synthesis and purification of long copper nanowires. Application to high performance flexible transparent electrodes with and without PEDOT: PSS. Nano Res. 2014, 7, 315-324.

Referring to FIG. 22, the copper nanowire electrode according to Example 2 shows a lower haze coefficient as compared to the conventional conductors. More particularly, the copper nanowire-based transparent conductor according to Example 2 (This work' in FIG. 22) shows a haze coefficient of 3% or less at a transmittance of 85% or higher, while the conventional conductors show a higher haze coefficient. This suggests that the ultrathin copper nanowires according to the present disclosure provide better results in terms of haze coefficient.

In addition, as compared to the conventional electrodes, the electrode using the copper nanowires obtained according to the present disclosure shows a higher transmittance and a lower sheet resistance. Herein, as conventional electrodes, Ref 31 was prepared according to Rathmell, A. R.; Wiley, B. J. The synthesis and coating of long, thin copper nanowires to make flexible, transparent conducting films on plastic substrates. Adv. Mater. 2011, 23, 4798-4803, Ref 33 was prepared according to Zhang, D.; Wang, R.; Wen, M.; Weng, D.; Cui, X.; Sun, J.; Li, H.; Lu, Y. Synthesis of ultralong copper nanowires for high-performance transparent electrodes. J. Am. Chem. Soc. 2012, 134, 14283-14286, Ref 34 was prepared according to Guo, H.; Lin, N.; Chen, Y; Wang, Z.; Xie, Q.; Zheng, T.; Gao, N.; Li, S.; Kang, H.; Cai, D.; Peng, D. Copper nanowires as fully transparent conductive electrodes. Sci. Rep. 2013, 3, 2323, Ref 40 was prepared according to Ahn, Y; Jeong, Y; Lee, D.; Lee, Y Copper nanowire-graphene core-shell nanostructure for highly stable transparent conducting electrodes. ACS Nano 2015, 9, 3125-3133, Ref 41 was prepared according to Hwang, C.; An, J.; Choi, B. D.; Kim, K.; Jung, S.; Baeg, K.; Kim, M.; Ok, K. M.; Hong, J. Controlled aqueous synthesis of ultra-long copper nanowires for stretchable transparent conducting electrode. J. Mater. Chem. C 2016, 4, 1441-1447, Ref 42 was prepared according to Cui, F.; Yu, Y; Dou, L.; Sun, J.; Yang, Q.; Schildknecht, C.; Schierle-Arndt, K.; Yang, P. Synthesis of ultrathin copper nanowires using tris(trimethylsilyl) silane for high-performance and low-haze transparent conductors. Nano Lett. 2015, 15, 7610-7615, Ref 47 was prepared according to Xiang, H.; Guo, T; Xu, M.; Lu, H.; Liu, S.; Yu, G. Ultrathin copper nanowire synthesis with tunable morphology using organic amines for transparent conductors. ACS Appl. Nano Mater. 2018, 1, 3754-3759, Ref 48 was prepared according to Kholmanov, I. N.; Domingues, S. H.; Chou, H.; Wang, X.; Tan, C.; Kim, J.-Y; Li, H.; Piner, R.; Zarbin, A. J. G.; Ruoff, R. S. Reduced Graphene Oxide/Copper Nanowire Hybrid Films as High-Performance Transparent Electrodes. ACS Nano 2013, 7, 1811-1816, Ref 49 was prepared according to Zhong, Z.; Woo, K.; Kim, I.; Hwang, H.; Kwon, S.; Choi, Y.-M.; Lee, Y; Lee, T. -M.; Kim, K.; Moon, J. Roll-to-roll-compatible, flexible, transparent electrodes based on self-nanoembedded Cu nanowires using intense pulsed light irradiation. Nanoscale 2016, 8, 8995-9003, and Ref 50 was prepared according to Yin, Z.; Song, S. K.; Cho, S.; You, D.-J.; Yoo, J.; Chang, S. T.; Kim, Y S. Curved copper nanowires-based robust flexible transparent electrodes via all-solution approach. Nano Res. 2017, 10, 3077-3091.

Referring to FIG. 23, the electrode using the copper nanowires according to Example 4 (This work in FIG. 23) shows a high transmittance of 91.9% at a sheet resistance of 28.5 ohm/sq, while the conventional electrodes show a transmittance of 90% or less at a high sheet resistance of 60 ohm/sq or higher.

In addition, the electrode using the copper nanowires according to Example 4 shows a low sheet resistance of 1.1-14 ohm/sq at a transmittance of 72-84%. This suggests that the electrode using the copper nanowires according to the present disclosure may be used as a high-quality conductor having a high transmittance, and preparation of ultrathin copper nanowires having a high aspect ratio provides an excellent effect.

## Claims

1. A transition metal chalcogenide as a reducing agent for growing metal nanostructures in a solution state.

2. Metal nanostructures grown by using a transition metal chalcogenide as a reducing agent.

3. The metal nanostructures according to claim 2, which are grown from the edge site of the transition metal chalcogenide.

4. The metal nanostructures according to claim 2, which have a size determined by the physical dimension of the transition metal chalcogenide.

5. A transparent electrode comprising the metal nanostructures as defined in claim 2.

6. A method for preparing metal nanostructures, comprising the steps of:
mixing a metal precursor and a reducing agent including TMD nanosheets to form a mixture; and
heat treating the mixture to reduce the metal precursor, thereby forming metal nanostructures.

7. The method for preparing metal nanostructures according to claim 6, wherein the reduction of the metal ion of the metal precursor is initiated at the edge site of the TMD nanosheets.

8. The method for preparing metal nanostructures according to claim 6, wherein the mixture further comprises a ligand agent that forms a complex with the metal ion of the metal precursor, and the ligand agent forms a complex with the metal ion of the metal precursor to induce anisotropic growth of the metal nanostructures.

9. The method for preparing metal nanostructures according to claim 8, wherein the ligand agent induces anisotropic growth of the metal nanostructures by lowering the stability of the metal nanostructures on one surface thereof through the anion of the metal precursor.
